# FASCICULE DE BREVET EUROPEEN

(11) **EP 3 216 331 B1**
(45) Date de publication et mention de la délivrance du brevet: **02.01.2019**
(21) Numéro de dépôt: 15808701.5
(22) Date de dépôt: 04.11.2015
(51) Int. Cl.: H05K 7/20

(54) **BAIE AVIONIQUE**
AVIONIKRAUM
AVIONICS BAY

(30) Priorité: 04.11.2014 FR 1460650
(43) Date de publication de la demande: 13.09.2017
(73) Titulaire: Safran Electrical & Power, 31702 Blagnac Cedex (FR); Airbus Operations, 31060 Toulouse (FR)
(72) Inventeur: AVIGNON, Philippe, Pierre, 31704 Blagnac Cedex (FR); BLINEAU, Jean-Marc, 31704 Blagnac Cedex (FR); FLEURY, Alexandre, 31704 Blagnac Cedex (FR); GOGE, François, 31704 Blagnac Cedex (FR); MAIRET, Philippe, 31400 Toulouse (FR)
(74) Mandataire: Regimbeau
(86) Numéro de dépôt international: PCT/FR2015/052976
(87) Numéro de publication internationale: WO 2016/071632

(56) Documents cités:
- DE-A1-102007 013 906
- US-A- 4 962 444
- US-A1- 2008 055 852
- US-A1- 2008 218 980
- US-A1- 2011 188 198

## Description

La présente invention concerne une baie avionique recevant des modules électriques pour un aéronef, ou plus généralement un véhicule de transport aérien, spatial, maritime ou terrestre.

Plus précisément, elle concerne le système de refroidissement intégré dans la baie avionique permettant de refroidir les modules électriques qui peuvent par exemple être des modules d'électronique de puissance.

### DOMAINE TECHNIQUE GÉNÉRAL ET ETAT DE LA TECHNIQUE

Les aéronefs modernes comportent de plus en plus de systèmes électriques. Ils doivent donc être équipés de modules électriques, comme des modules d'électroniques de puissance, pour assurer le fonctionnement des différents systèmes électriques (par exemple le démarrage électrique par un alternateur/démarreur, le conditionnement d'air et la pressurisation de l'aéronef au moyen de compresseurs électriques supprimant ainsi les prises d'air moteur, le dégivrage électrique des ailes et de l'empennage à la place du dégivrage à l'air, le freinage électrique à la place du freinage hydraulique, la rentrée/sortie électrique des trains d'atterrissage, le déplacement de l'aéronef au sol à partir de moteurs électriques logés dans les roues).

Ces modules électriques sont installés d'une manière amovible dans des baies avioniques à l'intérieur de l'aéronef. Plus précisément, les modules électriques sont enfichés dans des logements complémentaires auxdits modules électriques, la baie avionique comprenant plusieurs logements.

Ces modules électriques sont appelés modules remplaçables en ligne (ou LRU pour « Une Replacable Unit » selon la terminologie anglo-saxonne bien connue). En effet, ces modules LRU sont conçus pour pouvoir être remplacés individuellement lors d'une opération de maintenance en retirant un module défectueux et en installant à la place un nouveau module LRU en état de marche.

Ces modules LRU ont de fortes dissipations thermiques et ne peuvent pas se contenter de dispositifs de refroidissement classiques par ventilation et extraction d'air. Ainsi, il est connu d'associer ces modules LRU à des dispositifs de refroidissement fluidique afin de refroidir d'une manière efficace lesdits modules LRU. Habituellement, ces dispositifs de refroidissement fluidique sont composés d'un échangeur thermique surfacique (appelé « plaque froide ») qui est intégré dans chacun des modules LRU, et par un réservoir de fluide caloporteur ainsi qu'un dispositif de refroidissement dudit fluide. Ainsi, lorsque lesdits modules LRU sont installés dans la baie avionique, la plaque froide est reliée au réservoir de fluide caloporteur par un connecteur hydraulique à connexion/déconnexion rapide, de sorte que lorsqu'un module LRU est installé dans la baie avionique, il puisse être refroidi par une circulation du fluide caloporteur dans la plaque froide.

Cependant, une telle solution rencontre plusieurs difficultés. D'une part, la durée de vie des connecteurs hydrauliques à connexion/déconnexion rapide est limitée ; d'autre part un risque de fuite existe au niveau des connecteurs hydrauliques à connexion/déconnexion rapide, ce qui impose une opération de surveillance et de maintenance des connecteurs hydrauliques à connexion/déconnexion rapide.

De plus, une telle solution pose des problèmes lors du montage et du démontage d'un module LRU dans un logement de la baie avionique. En effet, les modules LRU peuvent avoir un poids important (plus de 25 kilogrammes), ce qui les rend difficiles à manipuler. Or, la connexion avec le dispositif de refroidissement est située sur une face latérale du module LRU, ce qui impose que le montage et le démontage du module LRU soit très précis afin de ne pas endommager le dispositif de refroidissement sur le module LRU et sur la baie.

### PRÉSENTATION GÉNÉRALE DE L'INVENTION

Un but général de l'invention est de proposer une baie avionique qui permet de faciliter les opérations de maintenance des modules électriques tout en assurant un refroidissement satisfaisant desdits modules électriques.

Plus particulièrement, selon un aspect, l'invention consiste en une baie avionique pour l'installation d'au moins un module électrique comprenant un système de refroidissement fluidique et un logement qui est complémentaire au module électrique et qui comprend une face avant ouverte par laquelle le module peut être installé d'une manière amovible à l'intérieur dudit logement, et une face arrière sur laquelle sont disposés des connecteurs électriques adaptés pour être connectés au module électrique, caractérisée en ce que le système de refroidissement fluidique comprend une plaque froide qui est disposée sur la face arrière du logement, ladite plaque froide étant adaptée pour refroidir le module électrique lorsque ledit module électrique est installé à l'intérieur du logement.

Selon une caractéristique particulière, la baie avionique comprend au moins un pion de guidage qui est disposé sur la face arrière du logement afin de guider le déplacement du module électrique à l'intérieur dudit logement.

Selon une caractéristique additionnelle, la baie avionique comprend deux pions de guidage.

Selon une caractéristique supplémentaire, la baie avionique comprend une butée amortissante disposée sur la face arrière du logement de sorte que le mouvement du module électrique soit amorti lorsque ledit module électrique atteint la face arrière du logement lors du montage dudit module électrique à l'intérieur dudit logement.

Selon une autre caractéristique, la baie avionique comprend une porte qui est disposée au niveau de la face avant du logement afin de protéger le module électrique lorsqu'il est installé à l'intérieur dudit logement.

Selon une caractéristique spécifique, la porte comprend un dispositif de pression permettant d'assurer que le module électrique soit plaqué avec une pression de contact suffisante contre la plaque froide lorsque ledit module électrique est installé à l'intérieur du logement et que la porte est fermée.

Selon une caractéristique additionnelle, la baie avionique comprend un matériau d'interposition qui est disposé de manière à être situé entre ladite plaque froide et le module électrique lorsque ledit module électrique est installé à l'intérieur du logement, de manière à augmenter les échanges thermiques entre le module électrique et la plaque froide.

Selon un aspect supplémentaire, l'invention porte sur un ensemble comprenant une baie avionique selon l'une des caractéristiques citées précédemment et un module électrique installé dans la baie avionique.

Selon un aspect additionnel, l'invention porte sur un aéronef comprenant une baie avionique selon l'une des caractéristiques citées précédemment.

### DESCRIPTIF DES FIGURES

D'autres caractéristiques, buts et avantages de la présente invention apparaitront à la lecture de la description détaillée qui va suivre, et en regard des dessins annexés, donnés à titre d'exemples non limitatifs et sur lesquels :
- la figure 1 représente une vue du dessus d'une baie avionique selon un premier mode de réalisation ;
- la figure 2 représente une vue de face d'un logement de la baie selon le premier mode de réalisation ;
- la figure 3 représente une vue de côté d'un logement selon le premier mode de réalisation dans lequel un module électrique est installé;
- la figure 4 représente une vue de dos d'un logement de la baie selon le premier mode de réalisation ;
- la figure 5 est une légende des figures 1 à 4 ;
- les figures 6a, 6b et 6c, représentent des variantes d'une face arrière du logement de la baie avionique.

### DESCRIPTION D'UN OU PLUSIEURS EXEMPLES DE MODE DE REALISATION

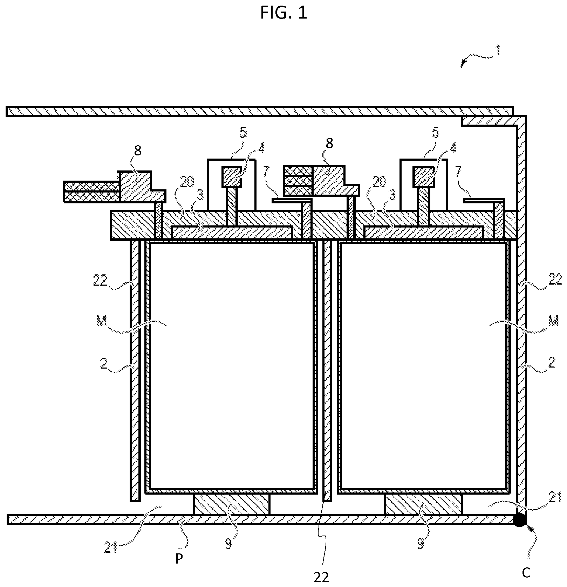

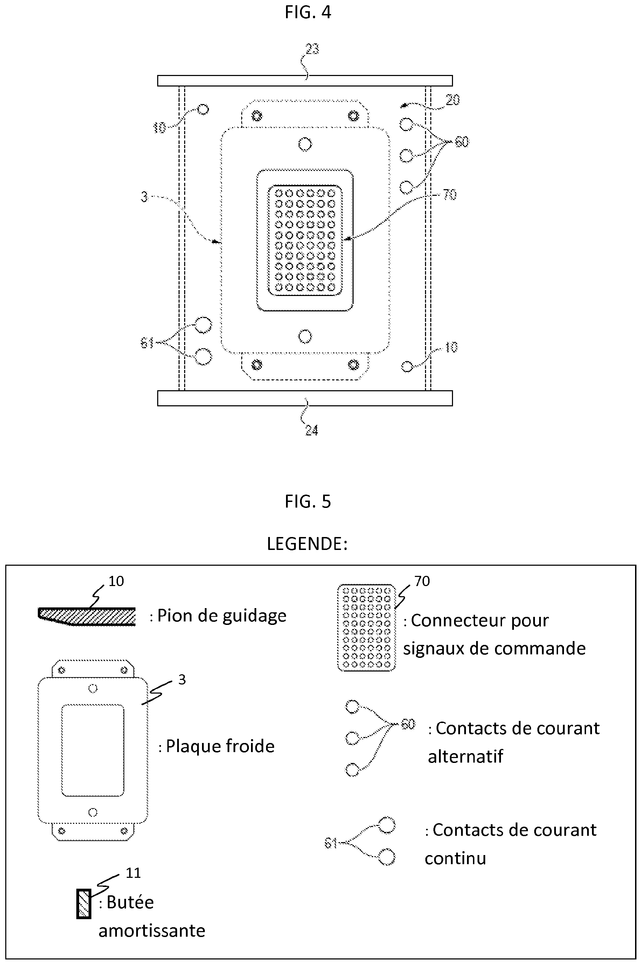

Comme représenté sur les figures 1 à 4, une baie avionique 1 comprend plusieurs logements 2 qui délimitent chacun une cavité de sorte qu'il est possible d'installer un module électrique M à l'intérieur de chacun des logements 2.

Chacun des logements 2 est de forme complémentaire au module électrique M qu'il doit recevoir. De manière générale les modules électriques M sont des parallélépipèdes rectangles. Ainsi, les logements 2 sont également des parallélépipèdes rectangles et ils comprennent :
- une face arrière 20 rectangulaire ;
- une face avant 21 rectangulaire qui est ouverte de manière à pouvoir installer les modules M dans les logements 2 par la face avant 21 ;
- deux faces latérales 22 rectangulaires ;
- une face supérieure 23 rectangulaire ;
- une face inférieure 24 rectangulaire.

Afin de pouvoir assurer la connexion électrique (une alimentation électrique et un signal de données) du module électrique M installé dans un logement 2, des connecteurs électriques sont disposés sur la face arrière 20 du logement 2 de manière à être connectés avec des connecteurs complémentaires disposés sur le module électrique M lorsque celui-ci est installé dans le logement 2. Ces connecteurs électriques sont reliés à un circuit électrique disposé à l'arrière de la face arrière 20, ledit circuit électrique étant composé d'une barre-bus 8 qui transmet l'alimentation électrique et de fils électriques 7 qui transmettent le signal de données au module électrique M.

Plus précisément, les connecteurs électriques disposés sur la face arrière 20 sont :
- trois contacts de courant alternatif 60 situés sur une partie périphérique de la face arrière 20 qui sont connectés à la barre-bus 8 ;
- deux contacts de courant continu 61 situés sur la partie périphérique de la face arrière 20 qui sont connectés à la barre-bus 8;
- un connecteur pour signaux de commande 70 qui est situé dans une partie centrale de la face arrière 20 et qui est connecté aux fils électriques 7.

Les aéronefs modernes nécessitant une puissance électrique de plus en plus importante, les modules électriques M (qui sont des modules d'électroniques de puissance qui permettent d'alimenter les divers appareils électriques des aéronefs) dissipent une grande quantité de chaleur. Ainsi, afin de refroidir les modules électriques M, une plaque froide 3 est disposée sur la partie centrale de la face arrière 20 de chaque logement 2. Ainsi, lorsqu'un module électrique M est installé dans un logement 2, il est en contact avec une plaque froide 3, et est refroidi.

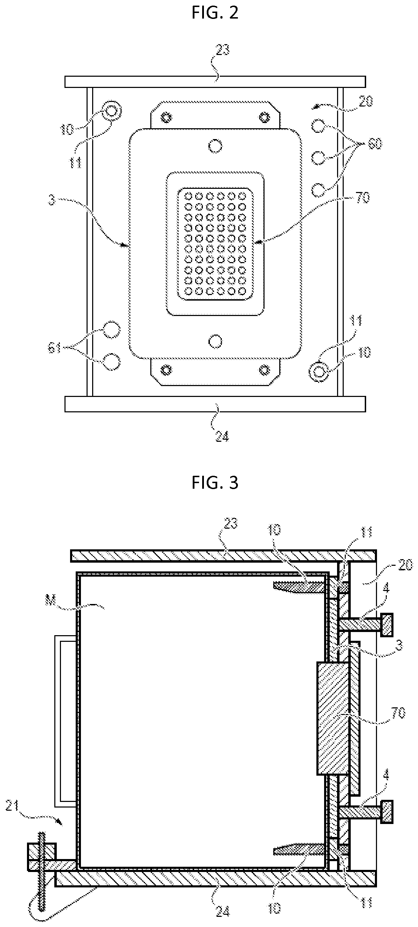

Comme représenté sur les figures 1 et 3, la plaque froide 3 qui est disposée sur la face arrière 20 est reliée par des connecteurs hydrauliques 4 à un réservoir de fluide caloporteur et à système de refroidissement dudit fluide caloporteur (non représentés).

Les plaques froides 3 sont des échangeurs thermiques surfaciques à l'intérieur desquels le fluide caloporteur circule. Le fluide caloporteur arrive froid dans les plaques froides 3, il se réchauffe en absorbant la chaleur dissipée par les modules électriques M, et il est refroidi par le système de refroidissement disposé à l'arrière de la baie avionique 1. Le système de refroidissement peut être par exemple un système à boucle diphasique.

L'avantage d'un tel mode de réalisation est que les connecteurs hydrauliques 4 sont des connecteurs qui assurent une connexion fixe avec la plaque froide 3, sans les inconvénients d'une connexion / déconnexion rapide, ce qui permet d'une part d'assurer une meilleure étanchéité entre les connecteurs hydrauliques 4 et la plaque froide 3 ; d'autre part de limiter la maintenance du système de refroidissement fluidique car les connecteurs hydrauliques 4 ont une durée de vie plus longue.

De plus, l'intégration des plaques froides 3 dans la baie est réalisée de telle sorte qu'elles ne travaillent pas structuralement.

Les plaques froides 3 sont disposées sur la face arrière 20 des logements 2 afin:
- d'avoir sur un même axe la pression de contact plaque froide 3 / module M et les contacts électriques
- d'éviter les frottements avec les parois latérales 22 du module M lors du montage ou du démontage du module électrique M. Ainsi, le montage et le démontage du module électrique M ne requièrent pas de mouvement précis lorsque le module électrique M est glissé dans le logement 2. Cet avantage est particulièrement intéressant car la manutention des modules électriques M peut être rendue compliquée par leur poids important.

Dans le premier mode de réalisation, sur chacune des faces arrière 20 des logements 2, la plaque froide 3 est disposée autour du connecteur pour signaux de commande 70, de manière à entourer ledit connecteur pour signaux de commande 70.

Afin d'améliorer le refroidissement des modules électriques M lorsqu'ils sont installés dans les logements 2, les composants électriques qui dissipent le plus de chaleur sont préférablement disposés à l'arrière des modules électriques M, de manière à être le plus proche possible des plaques froides 3. Simultanément, les plaques froides 3 sont conçues en fonction de la cartographie thermique du module M.

D'une manière avantageuse, et comme représenté sur les figures 2 à 4, la baie avionique 1 comprend deux pions de guidage 10 qui sont disposés sur la face arrière 20 de chacun des logements 2. Ces pions de guidage 10 sont constitués d'une tige qui fait saillie à l'intérieure de la cavité délimitée par chacun des logements 2. Ces pions de guidage 10 sont destinés à être introduits dans des trous complémentaires situés à l'arrière des modules électrique M, de manière à guider le déplacement des modules électriques M à l'intérieur des logements 2. Un tel guidage permet d'assurer que les différents connecteurs électriques situés sur la face arrière 20 des logements 2 soient bien alignés avec les connecteurs complémentaires disposés sur les modules électriques M, et ainsi assurer la connexion électrique des modules électriques M au circuit électrique de l'aéronef.

Préférentiellement, les pions de guidage 10 comprennent une extrémité qui est dirigée vers la face avant 21 des logements 2 et qui est biseautée, de sorte que même si les trous situés sur les modules électriques M ne sont pas parfaitement alignés avec les pions de guidage 10 lors du montage des modules électriques M, les pions de guidage 10 puissent rentrer dans lesdits trous.

Le nombre de pions de guidage 10 disposés sur la face arrière 20 est préférentiellement de deux, mais la baie avionique 1 peut ne comprendre qu'un seul pion de guidage 10, ou bien plus de deux pions de guidage 10 (par exemple trois).

Le fait que la face arrière 20 comprenne deux pions de guidage 10 permet de bloquer toute rotation du module électrique M, et n'autorise qu'un glissement selon la direction des pions de guidage 10, tout en limitant la surface de la face arrière occupée par les pions de guidage 10, et tout en permettant une tolérance dans le positionnement des pions de guidage 10 et des trous sur le module électrique.

Dans le mode de réalisation présenté sur les figures 2 à 4, les pions de guidage 10 sont situés sur la partie périphérique de la face arrière 20, de part et d'autre de la plaque froide 3 suivant une diagonale de ladite face arrière 20.

Comme représenté sur les figures 2 à 4, la baie avionique 1 comprend une butée amortissante 11 qui est disposée sur la face arrière 20 du logement 2, de manière à amortir le mouvement du module électrique M lorsqu'il s'approche de la face arrière 20 lors du montage dudit module électrique M à l'intérieur du logement 2.

Une telle butée amortissante permet d'empêcher que l'opération de montage du module électrique M n'endommage les connecteurs électriques et la plaque froide 3.

La butée amortissante 11 peut être constituée par un ressort, ou bien par un matériau élastique, par exemple du caoutchouc ou équivalent.

Dans le mode de réalisation présenté dans les figures 2 à 4, la baie 1 comprend deux butées amortissante 11 qui sont chacune constituées d'un anneau en un matériau élastique enfilé sur un pion de guidage 10.

La baie avionique 1 comprend également une porte P, comme représenté sur la figure 1, qui est disposée à l'avant de la baie avionique 1, au niveau des faces avants 21 des logements 2 que comprend ladite baie avionique 1. Cette porte P comprend une charnière C afin de permettre à un opérateur d'ouvrir la porte P lors d'une éventuelle opération de maintenance, et de fermer la porte P lorsqu'il n'est plus nécessaire qu'elle soit ouverte de sorte à protéger les modules électriques M qui sont installés dans les logements 2.

D'une manière préférentielle, la porte P comprend un dispositif de pression 9 qui permet d'assurer que le module électrique M soit plaqué avec une pression de contact suffisante contre la plaque froide 3 lorsque ledit module électrique M est installé à l'intérieur du logement 2 et que la porte P est fermée.

Le dispositif de pression 9 est constitué d'un ressort ou bien d'un matériau élastique qui est disposé sur une face de la porte P qui est dirigée vers l'intérieur de la baie 1, vers le module électrique M lorsqu'il est disposé dans le logement 2. Ainsi, lorsque la porte P est fermée, le dispositif de pression 9 appuie sur le module électrique M qui est disposé dans le logement 2, et le plaque ainsi contre la plaque froide 3 de manière à assurer le bon refroidissement du module électrique 2. L'élasticité du dispositif de pression est adaptée pour que la pression de contact du module électrique M contre la plaque froide 3 ne soit pas trop importante afin de ne pas détériorer ladite plaque froide 3.

Selon un mode de réalisation préférentiel, un matériau d'interposition, qui possède une conductivité thermique très élevée selon l'axe de pression, est disposé de manière à être situé entre ladite plaque froide 3 et le module électrique M lorsque ledit module électrique M est installé à l'intérieur du logement 2, de manière à augmenter les échanges thermiques entre le module électrique M et la plaque froide 3.

Le matériau d'interposition est préférentiellement utilisé lorsqu'une pression de contact entre la plaque froide 3 et le module électrique M ne peut pas être assurée.

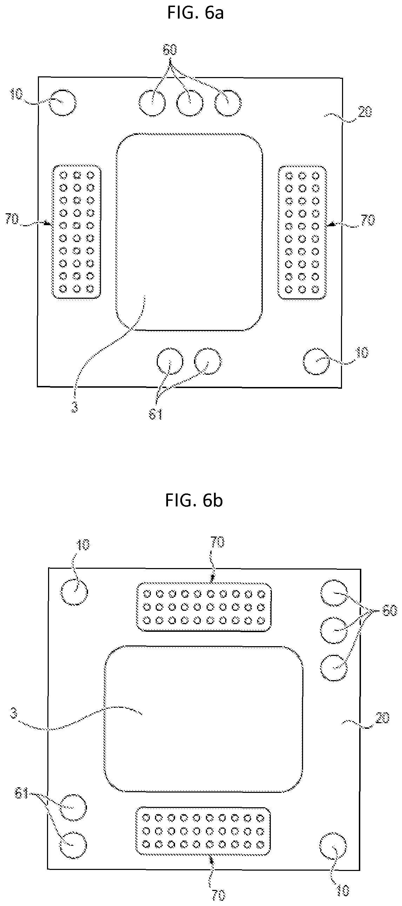

Comme représentés sur les figures 6a à 6c, plusieurs variantes de face arrière 20 du logement 2 sont possibles.

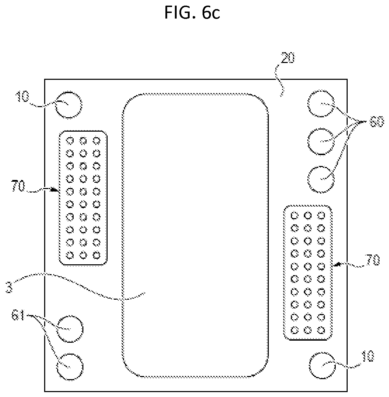

En effet, comme représenté sur les figures 6a, 6b et 6c, la face arrière 20 peut comprendre plusieurs connecteurs pour signaux de commande 70 qui sont situés dans la partie périphérique de la face arrière 20, de part et d'autre de la plaque froide 3 qui est située dans la partie centrale de ladite face arrière 20.

Les contacts de courant alternatif 60 et les contacts de courant continu 61 peuvent également être positionnés selon plusieurs variantes possibles, les figures 6a à 6c n'étant que des exemples des diverses variantes possibles.

## Revendications

1. Baie avionique (1) pour l'installation d'au moins un module électrique (M) comprenant un système de refroidissement fluidique et un logement (2) qui est complémentaire au module électrique (M) et qui comprend une face avant (21) ouverte par laquelle le module (M) peut être installé d'une manière amovible à l'intérieur dudit logement (2), et une face arrière (20) sur laquelle sont disposés des connecteurs électriques (60, 70, 71) adaptés pour être connectés au module électrique (M), **caractérisée en ce que** le système de refroidissement fluidique comprend une plaque froide (3) qui est disposée sur la face arrière (20) du logement (2), ladite plaque froide étant adaptée pour refroidir le module électrique (M) lorsque ledit module électrique (M) est installé à l'intérieur du logement (2).

2. Baie avionique (1) selon la revendication 1, **caractérisée en ce qu'**elle comprend au moins un pion de guidage (10) qui est disposé sur la face arrière (20) du logement (2) afin de guider le déplacement du module électrique (M) à l'intérieur dudit logement (2).

3. Baie avionique (1) selon la revendication 2, **caractérisée en ce qu'**elle comprend deux pions de guidage (10).

4. Baie avionique (1) selon l'une des revendications précédentes, **caractérisée en ce qu'**elle comprend un butée amortissante (11) disposé sur la face arrière (20) du logement (2) de sorte que le mouvement du module électrique (M) soit amorti lorsque ledit module électrique (M) atteint la face arrière (20) du logement (2) lors du montage dudit module électrique (M) à l'intérieur dudit logement (2).

5. Baie avionique (1) selon l'une des revendications précédentes, **caractérisée** ce qu'elle comprend une porte (P) qui est disposée au niveau de la face avant (21) du logement (2) afin de protéger le module électrique (M) lorsqu'il est installé à l'intérieur dudit logement (2).

6. Baie avionique (1) selon la revendication 5, **caractérisée en ce que** la porte (P) comprend un dispositif de pression (9) permettant d'assurer que le module électrique (M) soit plaqué avec une pression de contact suffisante contre la plaque froide (3) lorsque ledit module électrique (M) est installé à l'intérieur du logement (2) et que la porte (P) est fermée.

7. Baie avionique (1) selon l'une des revendications précédentes, **caractérisé en ce qu'**elle comprend un matériau d'interposition qui est disposé de manière à être situé entre ladite plaque froide (3) et le module électrique (M) lorsque ledit module électrique (M) est installé à l'intérieur du logement (2), de manière à augmenter les échanges thermiques entre le module électrique (M) et la plaque froide (3).

8. Ensemble comprenant une baie avionique (1) selon l'une des revendications 1 à 7 et un module électrique (M) installé dans la baie avionique (1).

9. Aéronef comprenant une baie avionique (1) selon l'une des revendications 1 à 7.

## Patentansprüche

1. Avionikraum (1) für die Installation mindestens eines elektrischen Moduls (M), umfassend ein Fluidkühlsystem und eine Aufnahme (2), die zu dem elektrischen Modul (M) komplementär ist und die eine offene Vorderseite (21) umfasst, durch die das Modul (M) lösbar im Inneren der Aufnahme (2) installierbar ist, und eine Rückseite (20), auf welcher der elektrische Verbinder (60, 70, 71) angeordnet sind, die ausgebildet sind, um mit dem elektrischen Modul (M) verbunden zu sein, **dadurch gekennzeichnet, dass** das Fluidkühlsystem eine kalte Platte (3) umfasst, die auf der Rückseite (20) der Aufnahme (2) angeordnet ist, wobei die kalte Platte ausgebildet ist, um das elektrische Modul (M) zu kühlen, wenn das elektrische Modul (M) im Inneren der Aufnahme (2) angeordnet ist.

2. Avionikraum (1) nach Anspruch 1, **dadurch gekennzeichnet, dass** er mindestens einen Führungsstift (10) umfasst, der auf der Rückseite (20) der Aufnahme (2) angeordnet ist, um die Verlagerung des elektrischen Moduls (M) im Inneren der Aufnahme (2) zu führen.

3. Avionikraum (1) nach Anspruch 2, **dadurch gekennzeichnet, dass** er zwei Führungsstifte (10) umfasst.

4. Avionikraum (1) nach einem der vorangehenden Ansprüche, **dadurch gekennzeichnet, dass** er einen Dämpfungsanschlag (11) umfasst, der auf der Rückseite (20) der Aufnahme (2) derart angeordnet ist, dass die Bewegung des elektrischen Moduls (M) gedämpft wird, wenn das elektrische Modul (M) die Rückseite (20) der Aufnahme (2) bei der Montage des elektrischen Moduls (M) im Inneren der Aufnahme (2) erreicht.

5. Avionikraum (1) nach einem der vorangehenden Ansprüche, **dadurch gekennzeichnet, dass** er eine Tür (P) umfasst, die im Bereich der Vorderseite (21) der Aufnahme (2) angeordnet ist, um das elektrische Modul (M) zu schützen, wenn es im Inneren der Aufnahme (2) angeordnet ist.

6. Avionikraum (1) nach Anspruch 5, **dadurch gekennzeichnet, dass** die Tür (P) eine Druckvorrichtung (9) umfasst, die erlaubt sicherzustellen, dass das elektrische Modul (M) mit einem ausreichenden Kontaktdruck gegen die kalte Platte (3) gedrückt wird, wenn das elektrische Modul (M) im Inneren der Aufnahme (2) angeordnet ist und wenn die Tür (P) geschlossen ist.

7. Avionikraum (1) nach einem der vorangehenden Ansprüche, **dadurch gekennzeichnet, dass** er ein Zwischenstellungsmaterial umfasst, das derart angeordnet ist, dass es sich zwischen der kalten Platte (3) und dem elektrischen Modul (M) befindet, wenn das elektrische Modul (M) im Inneren der Aufnahme (2) angeordnet ist, um den thermischen Austausch zwischen dem elektrischen Modul (M) und der kalten Platte (3) zu erhöhen.

8. Anordnung, umfassend einen Avionikraum (1) nach einem der Ansprüche 1 bis 7 und ein elektrisches Modul (M), das in dem Avionikraum (1) angeordnet ist.

9. Fluggerät, umfassend einen Avionikraum (1) nach einem der Ansprüche 1 bis 7.

## Claims

1. An avionics bay (1) for installation of at least one electrical module (M) comprising a fluid cooling system and a housing (2) which is complementary to the electrical module (M) and which comprises an open front face (21) through which the module (M) can be removably installed inside said housing (2), and a rear face (20) on which are arranged electrical connectors (60, 70, 71) suitable for being connected to the electrical module (M), **characterised in that** the fluid cooling system comprises a cold plate (3) which is arranged on the rear face (20) of the housing (2), said cold plate being suitable for cooling the electrical module (M) when said electrical module (M) is installed inside the housing (2).

2. The avionics bay (1) according to claim 1, **characterised in that** it comprises at least one guide pin (10) which is arranged on the rear face (20) of the housing (2) to guide displacement of the electrical module (M) inside said housing (2).

3. The avionics bay (1) according to claim 2, **characterised in that** it comprises two guide pins (10).

4. The avionics bay (1) according to any one of the preceding claims, **characterised in that** it comprises a damping stop (11) arranged on the rear face (20) of the housing (2) such that the movement of the electrical module (M) is attenuated when said electrical module (M) reaches the rear face (20) of the housing (2) during installation of said electrical module (M) inside said housing (2).

5. The avionics bay (1) according to any one of the preceding claims, **characterised in that** it comprises a door (P) which is arranged at the level of the front face (21) of the housing (2) to protect the electrical module (M) when it is installed inside said housing (2).

6. The avionics bay (1) according to claim 5, **characterised in that** the door (P) comprises a pressure device (9) for ensuring that the electrical module (M) is pressed with a sufficient contact pressure against the cold plate (3) when said electrical module (M) is installed inside the housing (2) and the door (P) is closed.

7. The avionics bay (1) according to any one of the preceding claims, **characterised in that** it comprises an interposition material which is arranged so as to be located between said cold plate (3) and the electrical module (M) when said electrical module (M) is installed inside the housing (2) so as to boost thermal exchanges between the electrical module (M) and the cold plate (3) .

8. An assembly comprising an avionics bay (1) according to any one of claims 1 to 7 and an electrical module (M) installed in the avionics bay (1).

9. An aircraft comprising an avionics bay (1) according to any one of claims 1 to 7.
